# EUROPEAN PATENT APPLICATION

(11) **EP 2 421 037 A1**
(43) Date of publication of application: **22.02.2012**
(21) Application number: 10764239.9
(22) Date of filing: 09.04.2010
(51) Int. Cl.: H01L 25/04, H01L 23/12

(54) **ELECTRONIC DEVICE MOUNTING STRUCTURE AND ELECTRONIC DEVICE MOUNTING METHOD**

(30) Priority: 14.04.2009 JP 2009098035
(71) Applicant: Fujikura, Ltd., Tokyo 135-8512 (JP)
(72) Inventor: YAMAMOTO, Satoshi, Chiba 285-8550 (JP)
(74) Representative: Cabinet Plasseraud
(86) International application number: PCT/JP2010/002598
(87) International publication number: WO 2010/119652

(57) **Abstract**

An electronic device mounting structure including: a supporting member that includes a supporting substrate, and a through electrode that penetrates the supporting substrate from a first principal surface that is one principal surface of the supporting substrate to a second principal surface that is the other principal surface, and that includes a projecting portion that projects from the second principal surface; and an electronic device that includes a device substrate on which a circuit is formed, and a through hole that penetrates between both principal surfaces of the device substrate, wherein the electronic device is arranged on the second principal surface of the supporting substrate so that the projecting portion of the supporting member is inserted into the through hole, and the circuit of the electronic device is electrically connected with the projecting portion.

## Description

### TECHNICAL FIELD

The present invention relates to an electronic device mounting structure for mounting an electronic device such as a semiconductor chip on a support member such as an interposer, and to a method of mounting the electronic device.
Priority is claimed on Japanese Patent Application No. 2009-098035, filed April 14, 2009, the content of which is incorporated herein by reference.

### BACKGROUND ART

With the increasing sophistication of electrical equipment such as mobile phones in recent years, there is a demand for further increases in the speed and performance of electronic devices that are used in the equipment. In order to meet these demands, technical development is required not only to increase the speed of the device itself through miniaturization and the like, but also to increase the speed and density of the package of the device.
As technologies that achieve high-density mounting of electronic devices, research and development of various through-electrode formation technologies and through-wiring substrate formation technologies have been actively advanced. For example, three-dimensional stacking technology that laminates and mounts chips using through wiring and System in Package (SiP) technology that uses a through wiring substrate having through electrodes formed therein have been proposed.

Patent Document 1 discloses a substrate having a through electrode that is fabricated from a silicon wafer having an embedded insulating layer between a supporting substrate layer and a silicon layer. In this substrate having a through electrode, a blind via hole is formed reaching the silicon layer to a depth that allows formation of a recess. An inner wall insulating layer is applied onto the blind via hole to form a conductive layer. Then, by removing the silicon layer, the portion of the conductive layer corresponding to the recess is exposed as a wafer outer raised portion.

Patent Document 2 discloses a method for manufacturing a semiconductor device that includes: laminating three or more semiconductor chips which each have a terminal with two ends projecting from a substrate, on an interposer; positioning the semiconductor chips and the interposer so as to align the adjacent terminals with each other; and bonding the adjacent terminals together in a lot.

### PRIOR ART DOCUMENTS

### PATENT DOCUMENTS

[Patent Document 1] Japanese Unexamined Patent Application, First Publication No. 2005-93954
[Patent Document 2] Japanese Unexamined Patent Application, First Publication No. 2003-282819

### DISCLOSURE OF INVENTION

### PROBLEMS TO BE SOLVED BY THE INVENTION

In order to achieve further increases in the speed and density of an apparatus on which an electronic device is mounted, it is necessary to ensure a low-resistance electrical connection between the top of the supporting member, such as an interposer, and the semiconductor chip, or among the laminated semiconductor chips. In order to secure such a low-resistance electrical connection, high positional accuracy between the terminals and reduced resistance of the joined portions between terminals are needed. In conventional mounting technology, in order to prevent position gaps of the opposing terminals between substrates, various position control measures are taken. However, in order to realize a much more high density assembly, it is desired to be able to directly observe the terminal positions on the lower side substrate during the semiconductor chip lamination work.

The present invention was achieved in view of the above circumstances, and has an object of providing an electronic device mounting structure and an electronic device mounting method that make it possible to easily mount an electronic device such as a semiconductor chip on a support member such as an interposer.

### MEANS FOR SOLVING THE PROBLEMS

In order to solve the aforementioned issues, the present invention employs the following. In particular, an electronic device mounting structure according to a first aspect of the present invention includes: a supporting member that includes a supporting substrate, and a through electrode that penetrates the supporting substrate from a first principal surface that is one principal surface of the supporting substrate to a second principal surface that is the other principal surface, and that includes a projecting portion that projects from the second principal surface; and an electronic device that includes a device substrate on which a circuit is formed, and a through hole that penetrates between both principal surfaces of the device substrate, wherein the electronic device is arranged on the second principal surface of the supporting substrate so that the projecting portion of the supporting member is inserted into the through hole, and the circuit of the electronic device is electrically connected with the projecting portion.
It may be arranged such that the electronic device mounting structure includes a plurality of the electronic devices, wherein each of the electronic devices is laminated on the second principal surface of the supporting substrate.
It may be arranged such that the supporting member includes, on the second principal surface of the supporting substrate, a plurality of device arrangement regions in which the electronic devices are arranged by the projecting portion.
It may be arranged such that the electronic device mounting structure further includes a protective layer that includes the electronic devices within itself.
It may be arranged such that a layer of solder is formed on the outer periphery surface of the projecting portion over the entire length of the projecting portion, and the circuit of the electronic device and the projecting portion are electrically connected by solder that is melted out from the layer of solder.
It may be arranged such that the supporting member includes a connection terminal on the first principal surface side.
An electronic device according to a second aspect of the present invention includes the above-described electronic device mounting structure.

Further, an electronic device mounting method according to a third aspect of the present invention includes: a first step of preparing a supporting member including a supporting substrate, and a through electrode that penetrates the supporting substrate from a first principal surface that is one principal surface of the supporting substrate to a second principal surface that is the other principal surface, and that includes a projecting portion that projects from the second principal surface; a second step of preparing an electronic device that includes a device substrate, and a through hole that penetrates between both principal surfaces of the device substrate; and a third step of arranging the electronic device on the second principal surface of the supporting substrate so that the projecting portion of the supporting member is inserted into the through hole of the electronic device, and electrically connecting the circuit of the electronic device and the projecting portion.

It may be arranged such that the first step includes: a step of laminating, on the second principal surface of the supporting substrate, a projecting portion formation auxiliary layer having a thickness greater than the height of the projecting portion; a step of forming a through hole that penetrates from the first principal surface to the second principal surface of the supporting substrate; a step of forming a communication hole extending from the through hole of the supporting substrate to reach the interior of the projecting portion formation auxiliary layer; a step of filling with a conductor the through hole of the supporting substrate and the communication hole; and a step of exposing the second principal surface of the supporting substrate by removing the projecting portion formation auxiliary layer, and forming a through electrode that consists of the conductor, penetrates the supporting substrate from the first principal surface to the second principal surface, and includes the projecting portion that projects from the second principal surface.
It may be arranged such that the first step includes: a step of farming a hole in a base material that has a thickness greater than the sum of the thickness of the supporting substrate and the height of the projecting portion from a surface that becomes the first principal surface of the supporting substrate; a step of filling the hole with a conductor; and a step of forming the second principal surface of the supporting substrate by removing a portion of the base material from the opposite side of the first principal surface of the base material until a portion of the conductor is exposed, and forming a through electrode that consists of the conductor, penetrates the supporting substrate from the first principal surface to the second principal surface, and includes the projecting portion that projects from the second principal surface.
It may be arranged such that the first step includes a step of forming a layer of solder on the outer periphery surface of the projecting portion over the entire length of the projecting portion, and the third step includes a step of inserting the projecting portion of the supporting member into each through hole of a plurality of the electronic devices to arrange the electronic devices in a layered manner on the second principal surface of the supporting substrate, and a step of electrically connecting all at once each circuit of the plurality of electronic devices and the projecting portion by melting the layer of solder.

### EFFECT OF THE INVENTION

According to the present invention, even after the projecting portion of the support member has been inserted into each through hole of the plurality of electronic devices, it is possible to confirm the position of the projecting portion from above the electronic device. Therefore, high-density mounting of the electronic devices can be easily performed. In addition, since the projecting portion is a unit conductor that is continuous in the lengthwise direction, even if a plurality of electronic devices are mounted in a layered manner, no joining portion will be present between the electronic devices. As a result, it is possible to achieve a lower resistance of the electrical connections among the electronic devices and the reduction of the total thickness of the layered electronic devices.

### BRIEF DESCRIPTION OF THE DRAWINGS

FIG. 1A is a cross-sectional view that schematically shows the electronic device mounting structure according to the first embodiment of the present invention.
FIG. 1B is a cross-sectional view that schematically shows one example of the supporting member that is used in the electronic device mounting structure according to the embodiment.
FIG. 2A is a cross-sectional view that schematically shows the first stage, among the manufacturing steps of the supporting member of FIG. 1B and FIG. 6B.
FIG. 2B is a cross-sectional view that schematically shows the stage following FIG. 2A.
FIG. 2C is a cross-sectional view that schematically shows the stage following FIG. 2B.
FIG. 2D is a cross-sectional view that schematically shows the stage following FIG. 2C.
FIG 3A is a cross-sectional view that schematically shows the stage following FIG. 2D, among the manufacturing steps of the supporting member of FIG. 1B.
FIG. 3B is a cross-sectional view that schematically shows the stage following FIG. 3A.
FIG. 3C is a cross-sectional view that schematically shows the stage following FIG. 3B.
FIG. 3D is a cross-sectional view that schematically shows the stage following FIG. 3C.
FIG. 4A is a cross-sectional view that schematically shows the electronic device mounting structure according to the second embodiment of the present invention.
FIG. 4B is a cross-sectional view that schematically shows an example of the supporting member that is used in the electronic device mounting structure according to the embodiment.
FIG. 5A is a cross-sectional view that schematically shows the first stage, among the manufacturing steps of the supporting member of FIG. 4B.
FIG. 5B is a cross-sectional view that schematically shows the stage following FIG.5A.
FIG. 5C is a cross-sectional view that schematically shows the stage following FIG. 5B.
FIG. 5D is a cross-sectional view that schematically shows the stage following FIG. 5C.
FIG. 6A is a cross-sectional view that schematically shows the electronic device mounting structure according to the third embodiment of the present invention.
FIG. 6B is a cross-sectional view that schematically shows an example of the supporting member that is used in the electronic device mounting structure according to the embodiment.
FIG. 7A is a cross-sectional view that schematically shows the stage that follows FIG. 2D, among the manufacturing steps of the supporting member of FIG. 6B.
FIG. 7B is a cross-sectional view that schematically shows the stage following FIG. 7A.
FIG. 7C is a cross-sectional view that schematically shows the stage following FIG. 7B.
FIG. 7D is a cross-sectional view that schematically shows the stage following FIG. 7C.
FIG. 8A is a cross-sectional view that schematically shows the electronic device mounting structure according to the fourth embodiment of the present invention.
FIG. 8B is a cross-sectional view that schematically shows one example of the supporting member that is used in the electronic device mounting structure according to the embodiment.
In FIG. 9A, (a) is a cross-sectional view that schematically shows the first stage, among the manufacturing steps of the supporting member of FIG. 8B, while (b) is an arrow view of a portion of (a) seen from below, serving as an explanatory view that shows the shape of the through hole 12 and the core 17.
FIG. 9B is a cross-sectional view that schematically shows the stage following FIG. 9A.
FIG. 9C is a cross-sectional view that schematically shows the stage following FIG. 9B.
FIG. 10A is a cross-sectional view that schematically shows the stage following FIG. 9C, among the manufacturing steps of the supporting member of FIG. 8B.
FIG. 10B is a cross-sectional view that schematically shows the stage following FIG. 10A.
FIG. 10C is a cross-sectional view that schematically shows the stage following FIG. 10B.
FIG. 11A is a cross-sectional view that schematically shows the stage following FIG. 10C, among the manufacturing steps of the supporting member of FIG. 8B.
FIG. 11B is a cross-sectional view that schematically shows the stage following FIG. 11A.
FIG. 11C is a cross-sectional view that schematically shows the stage following FIG. 11B.
FIG. 11D is a cross-sectional view that schematically shows the stage following FIG. 11C.
FIG. 12 is a cross-sectional view that schematically shows a modified example of the supporting member that is used in the electronic device mounting structure of the present invention.
FIG. 13 is a cross-sectional view that schematically shows a modified example of the supporting member that is used in the electronic device mounting structure of the present invention.
FIG. 14 is a cross-sectional view that schematically shows one aspect that has a plurality of device arrangement regions in the electronic device mounting structure of the present invention.
FIG. 15 is a cross-sectional view that schematically shows one aspect that has a protective layer that includes the electronic device within itself in the electronic device mounting structure of the present invention.
FIG. 16 is a plan view that schematically shows an example of the pad arrangement on the device substrate.
FIG. 17A is a cross-sectional view that schematically shows the first stage, among the steps of processing the device substrate to mount it on the supporting member.
FIG. 17B is a cross-sectional view that schematically shows the stage following FIG. 17A.
FIG. 17C is a cross-sectional view that schematically shows the stage following FIG. 17B.
FIG. 17D is a cross-sectional view that schematically shows the stage following FIG. 17C.
FIG. 18A is a cross-sectional view that schematically shows an example of the state of the electronic devices being in a layered arrangement using the support member in which a layer of solder is provided on the projecting portion.
FIG. 18B is a cross-sectional view that schematically shows an example of the electronic device mounting structure that is manufactured using the electronic devices that are arranged in a layered manner as shown in FIG. 18A.

### EMBODIMENTS FOR CARRYING OUT THE INVENTION

Hereinbelow the preferred embodiments of the present invention shall be described with reference to the drawings.

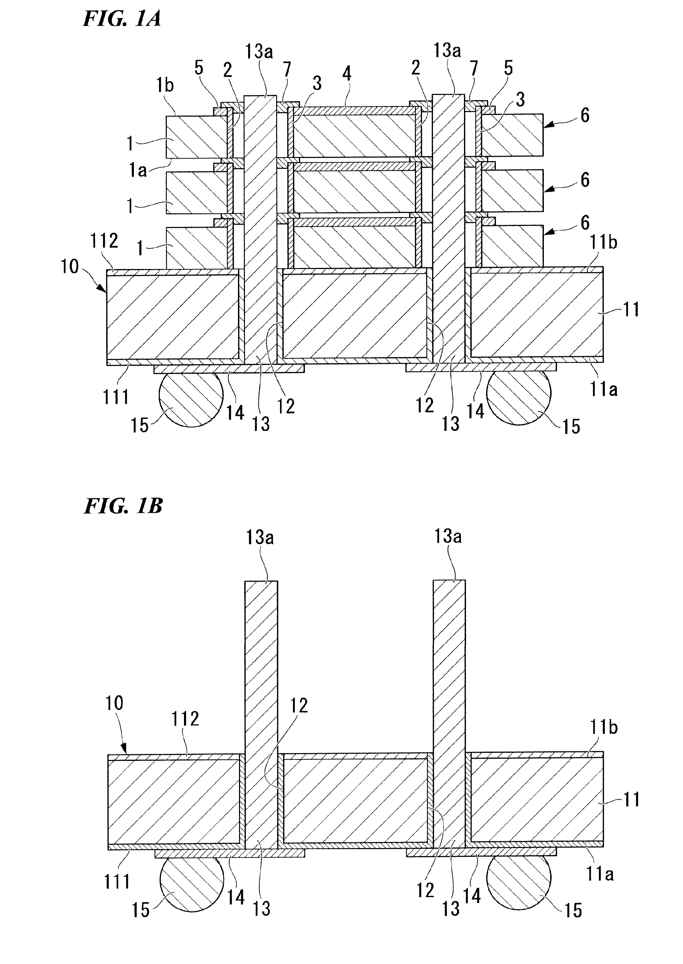

FIG. 1A to FIG. 3D show the electronic device mounting structure and mounting method using a supporting member 10, according to a first embodiment of the present invention.
The supporting member 10 shown in FIGS. 1A and 1B is a supporting member that includes a supporting substrate 11, and a through electrode 13 that penetrates the supporting substrate 11 from a first principal surface 11a that is one principal surface of the supporting substrate 11 to a second principal surface 11b that is the other principal surface, and includes a projecting portion 13a that projects from the second principal surface 11b, in order to mount an electronic devices 6 on the second principal surface 11b side. This supporting member 10 may further include a connection terminal 15 such as a solder bump on the first principal surface 11a side, and is capable of electrically connecting the circuit 4 of the electronic device 6, and an external substrate (not shown), such as a printed circuit board, via the through electrode 13, the circuit 14 and the connection terminal 15.

In the case of the present embodiment, the supporting substrate 11 consists of a semiconductor substrate, such as a silicon (Si) substrate. Insulating layers 111, 112 such as a silicon dioxide film (SiO₂ are formed on both principal surfaces 11a and 11b and on the inner wall of a through hole 12, and thereby provide insulation between the circuit 14 and the semiconductor substrate and between the through electrode 13 and the semiconductor substrate. In the case of FIG. 1A and FIG. 1B, the insulating layer 111 is formed as a continuous layer from the first principal surface 11a of the supporting substrate 11 to the inner wall of the through hole 12, but separate insulating layers may be formed on the first principal surface 11a of the supporting substrate 11 and the inner wall of the through hole 12.

The electronic device 6 that is used in the present embodiment is a semiconductor chip that has a device substrate 1, and a through hole 2 that penetrates both principal surfaces 1a, 1b of the device substrate 1. In the case of using a semiconductor chip, the device substrate 1 is a semiconductor substrate such as a silicon (Si) substrate, and it is preferable to provide an insulating layer 3 on the inner wall of the through hole 2 in order to provide insulation between the projecting portion 13a of the through electrode 13 and the semiconductor substrate.
The circuit 4 that constitutes the electronic device is formed on the principal surface 1b of the device substrate 1. It is possible to constitute a portion of the circuit 4 as a semiconductor circuit. The type of electronic device is not particularly limited, and examples include a memory device or sensor device.
A pad 5 that is connected to the circuit 4 is formed at the periphery of the through hole 2. The pad 5 and the projecting portion 13a are electrically connected by an electrically conductive bonding material 7 such as solder or conductive paste.

As shown in FIG. 1A, the electronic device 6 is arranged on the second principal surface 11b of the supporting substrate 11 so that the projecting portion 13a of the supporting member 10 is inserted into the through hole 2 of the electronic device 6. In addition, the circuit 4 of the electronic device 6 and the projecting portion 13a are electrically connected. By layering a plurality of the electronic devices 6 so that the projecting portion 13a is inserted into each through hole 2 of the plurality of electronic devices 6, multi-layering of the electronic devices 6 can be achieved.

Moreover, electronic circuit components such as resistors, capacitors, and inductors may be provided on the circuit 14 of the supporting member 10. Also, in the case of the supporting substrate 11 consisting of a semiconductor substrate, a semiconductor circuit may be formed on the supporting substrate 11.

According to the electronic device mounting structure of the present embodiment, even after the projecting portion 13a has been inserted into each through hole of the plurality of electronic devices 6, it is possible to confirm the position of the projecting portion 13a from above the electronic devices 6. Therefore, high-density mounting of the electronic devices 6 can be easily performed. Also, since the projecting portion 13a is a unit conductor that is continuous in the lengthwise direction, even if a plurality of electronic devices 6 are mounted in a layered manner, no joining portion will be present between the electronic devices 6. As a result, it is possible to achieve lower resistance of the electrical connections among the electronic devices 6 and reduction of the total thickness of the layered electronic devices 6.

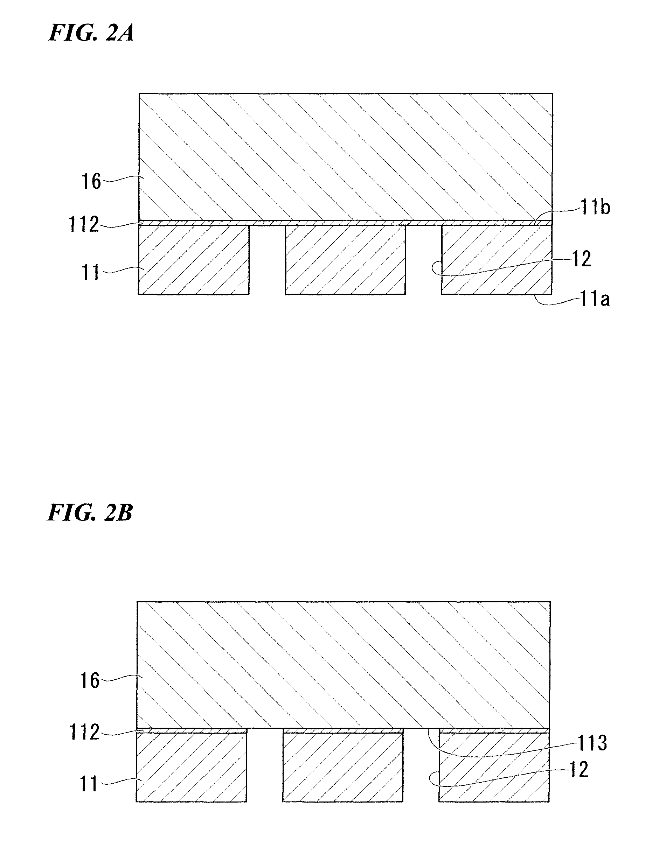

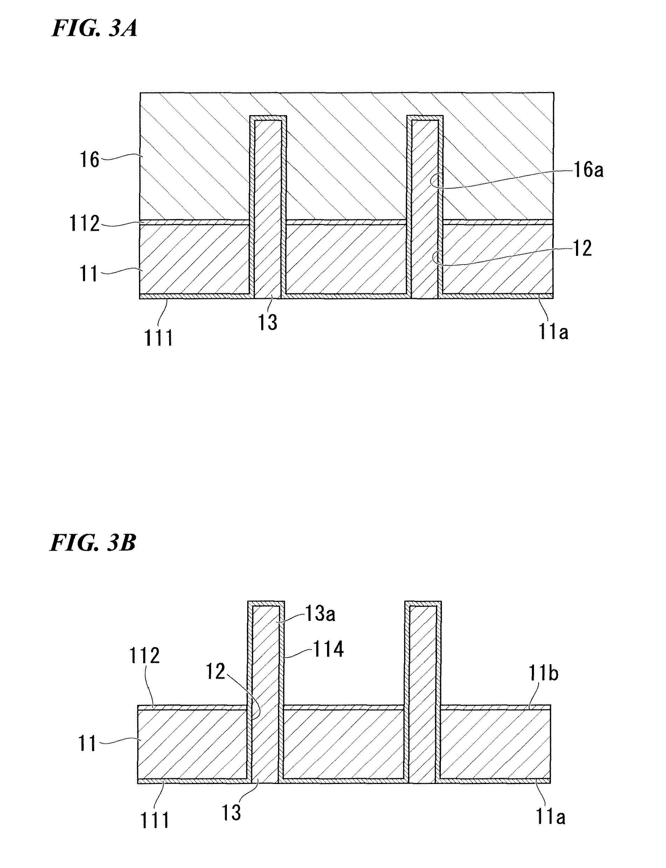

It is possible to manufacture the supporting member 10 of the present embodiment by the manufacturing method shown in FIG. 2A to FIG. 2D, and FIG. 3A to FIG. 3D.
First, as shown in FIG. 2A, a projecting portion formation auxiliary layer 16 is laminated on the second principal surface 11b side of the supporting substrate 11, and the through hole 12 is formed that penetrates from the first principal surface 11a of the supporting substrate 11 to the second principal surface 11b. The thickness of the projecting portion formation auxiliary layer 16 is greater than the height of the projecting portion 13a that is provided on the supporting member 10.

In the case of the present embodiment, the supporting substrate 11 is a silicon substrate, the projecting portion formation auxiliary layer 16 is a silicon layer, and an embedded insulating layer 112 is provided therebetween. In addition, following the through hole 12, as shown in FIG. 2B, a hole 113 is formed in the embedded insulating layer 112.
It is possible to use an SOI substrate as the Si/SiO₂/Si layered product. The dimensions of each layer are not particularly limited, and may be suitably determined in accordance with the intended purpose of the supporting member 10. As a concrete example, the thickness of the supporting substrate 11 is, for example, 150 µm, the thickness of the projecting portion formation auxiliary layer 16 is, for example, 200 µm, the height of the projecting portion 13a is, for example, 180 µm, and the diameter of the through hole 12 (corresponding to the outer diameter of the projecting portion 13a) is, for example, 60 µm.

Methods of forming a hole in Si include a Bosch process that alternately performs Si etching by a high-density plasma using SF₆ gas, and passivation film formation on the side wall of the hole using C₄F₈ gas or the like. It is also possible to employ dry etching techniques other than the Bosch process, wet etching using a chemical solution, and physical processing by a laser or the like.
Methods of forming a hole in SiO₂ include dry etching using CF₄ gas or the like, wet etching using a chemical solution, and physical processing by a laser or the like.

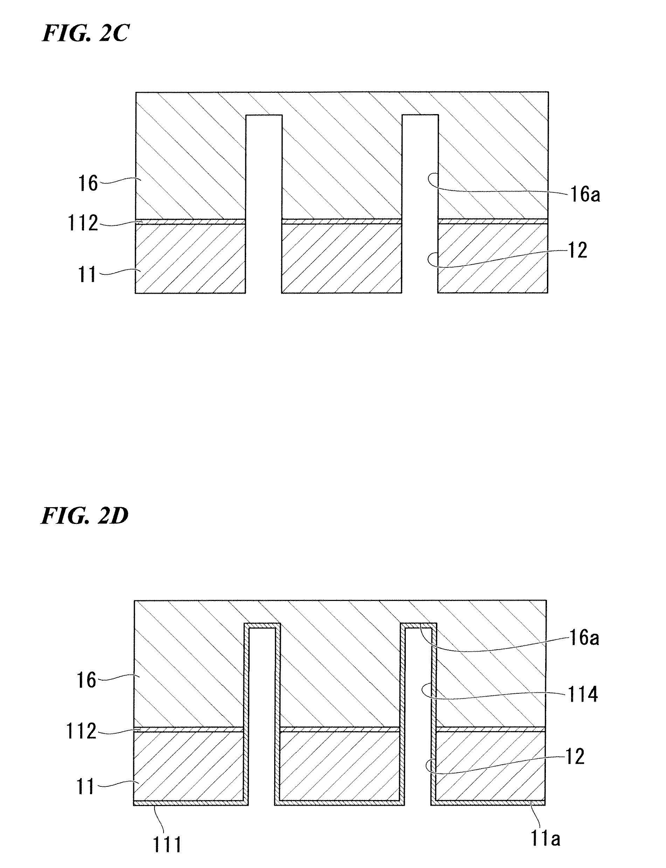

Next, as shown in FIG. 2C, a communication hole 16a is formed extending from the through hole 12 so as to reach the interior of the projecting portion formation auxiliary layer 16. The depth of the communication hole 16a in the projecting portion formation auxiliary layer 16 is substantially the same as the height of the projecting portion 13a.
Next, as shown in FIG. 2D, the insulating layer 111 is formed on the inner wall of the through-hole 12, and the first principal surface 11a of the supporting substrate 11. Note that the formation (existence) of the insulating layer 111 is discretionary, and it may be performed as needed. For example, if it is an insulating layer that consists of SiO₂, it will be obtained by the plasma chemical vapor deposition method that uses tetraethoxysilane (TEOS) as a raw material, the plasma CVD method that uses silane (SiH₄) or the like, and thermal oxidation of Si. The material of the insulating layer is not limited to SiO₂, and may be other insulating materials, such as silicon nitride (SiN) or insulating resin. The insulating layer 111 can also be continuously formed on the inner wall of the communication hole 16a. Note that the reference numeral 114 in the drawing distinguishes the insulating layer 111 in the communication hole 16a.

Next, as shown in FIG. 3A, the through-hole 12 and the communication hole 16a are filled with a conductor 13. The through electrode 13 which has the projecting portion 13a is constituted by this conductor 13.
As the conductor 13, metals such as copper (Cu) and tungsten (W), alloys such as Au-Sn, and nonmetallic conductors such as polysilicon, can be used. As the filling method, it is possible to suitably apply a plating method, a sputtering method, a molten metal filling method, chemical vapor deposition, and the like.

Next, as shown in FIG. 3B, the projecting portion formation auxiliary layer 16 is completely removed. That is, the entire surface of the second principal surface 11b (in greater detail, the insulating layer 112) of the supporting substrate 11 is exposed. When the projecting portion formation auxiliary layer 16 consists of Si, methods of removal include dry etching using SF₆ gas and the like as well as wet etching using a chemical solution.

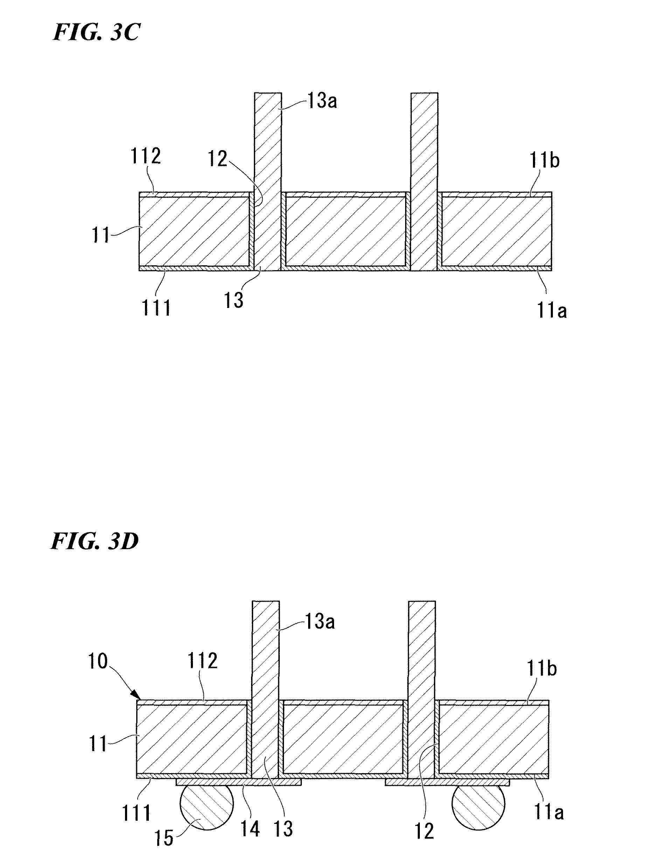

When the insulating layer 114 has been formed also in the interior of the communication hole 16a in FIG. 2D, as shown in FIG. 3C, the insulating layer 114 on the surface of the projecting portion 13a is removed. When the insulating layer 114 consists of SiO₂, methods of removal include dry etching using CF₄ gas and the like as well as wet etching using a chemical solution.
When removing the insulating layer 114 from the surface of the projecting portion 13a, in order to protect the insulating layer 112 on the second principal surface 11b, it is preferable to form a protective layer, such as a resist layer, on the insulating layer 112 in advance. Alternatively, it may be arranged such that the thickness of the insulating layer 112 is made thicker beforehand so that the insulating layer 112 with a sufficient thickness remains even if removal of the insulating layer 114 is completed. In this case, the insulating layer 114 on the projecting portion 13a surface can be removed without forming a protective layer, such as a resist layer.

Then, as shown in FIG. 3D, the circuit 14 that is electrically connected with the through electrode 13, and the connection terminal 15 such as a solder bump that is electrically connected with the circuit 14 are formed on the first principal surface 11a side of the supporting substrate 11. Thereby, the supporting member 10 of the present embodiment is completed.

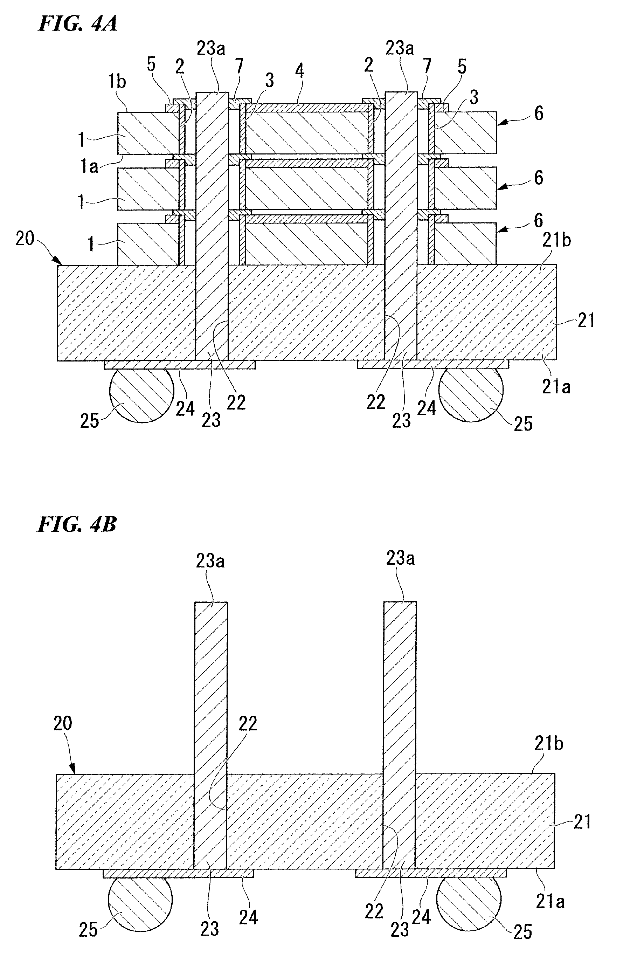

FIG. 4A to FIG. 5D show the electronic device mounting structure and mounting method using a supporting member 20 according to the second embodiment of the present invention.
In the case of the present embodiment, a supporting substrate 21 consists of an insulating substrate, such as a glass substrate.
In the same manner as the above-mentioned first embodiment, the supporting member 20 has a supporting substrate 21, and a through electrode 23 that penetrates the supporting substrate 21 from a first principal surface 21a to a second principal surface 21b, and has a projecting portion 23a that projects from the second principal surface 21b, with the electronic device 6 mounted on the second principal surface 21b side. In the case of the present embodiment, as shown in FIG. 4A and FIG. 4B, since the supporting substrate 21 does not conduct with the through electrode 23 and the circuit 24, there is no need to provide an insulating layer on the principal surfaces 21a and 21b and on the inner wall of the through hole 22.

The electronic device 6 is arranged on the second principal surface 21b so that the projecting portion 23a of the supporting member 20 is inserted into a through-hole 2. Moreover, the circuit 4 of the electronic device 6 and the projecting portion 23a are electrically connected. By stacking a plurality of the electronic devices 6 so that the projecting portion 23a is inserted into each through hole 2 of the plurality of electronic devices 6, multi-layering of the electronic devices 6 can be achieved.
Moreover, the supporting member 20 has a connection terminal 25 such as a solder bump on the first principal surface 21a side, and is capable of electrically connecting the circuit 4 of the electronic device 6 and an external substrate (not shown) such as a printed circuit board, via the through electrode 23, the circuit 24 and the and the connection terminal 25.
It is also possible to provide electrical components such as resistors, capacitors, and inductors on the circuit 24 of the supporting member 20.

According to the electronic device mounting structure of the present embodiment, even after the projecting portion 23a has been inserted into each through hole 2 of the plurality of electronic devices 6, it is possible to confirm the position of the projecting portion 23a from above the electronic devices 6. Therefore, high-density mounting of the electronic devices 6 can be easily performed. Moreover, since the projecting portion 23a is a unit conductor that is continuous in the lengthwise direction, even if a plurality of electronic devices 6 are mounted in a layered manner, no joining portion will be present between the electronic devices 6. As a result, it is possible to achieve a reduction in the resistance of the electrical connections among the electronic devices 6 and reduction of the total thickness of the layered electronic devices 6.
Further, according to the present embodiment, since the supporting substrate 21 consists of an insulator, it is not necessary to form an insulating layer on the substrate surface and inner wall of the through hole. As a result, it is possible to simplify the manufacturing process.

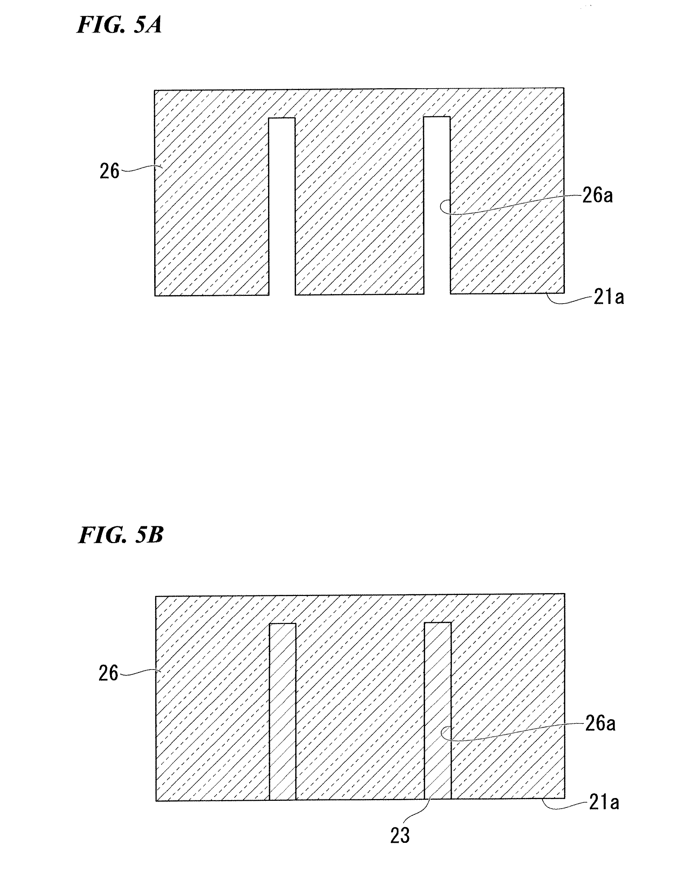

The supporting member 20 of the present embodiment can be manufactured by the method shown, for example, in FIG. 5A to FIG. 5D.
First, as shown in FIG. 5A, a base material 26 that has a larger thickness than the sum of the thickness of the supporting substrate 21 and the height of the projecting portion 23a of the supporting member 20 after completion is prepared, and a hole 26a is formed from the side that becomes the first principal surface 21a of the supporting substrate 21. The depth of the hole 26a is (substantially) equal to the sum of the thickness of the supporting substrate 21 and the height of the projecting portion 23a.
The dimensions of each portion are not particularly limited and can be suitably determined according to the application of the supporting member 20. As a concrete example, the thickness of the supporting substrate 21 is, for example, 150 µm, the thickness of the base material 26 is, for example, 500 µm, the depth of the hole 26a is, for example, 320 µm, and the diameter of the hole 26a is, for example, 60 µm.

A method of forming the a fine hole 26a in the glass base material 26 includes a method that modifies the portion of the glass which serves as the hole 26a by femtosecond laser irradiation, and then removes that modified portion by wet etching, as disclosed in Japanese Unexamined Patent Application, First Publication No. 2006-303360. In addition, the hole 26a may also be formed by dry etching that uses gas or the like, wet etching that uses a chemical solution, and physical processing by a laser or the like.

Next, as shown in FIG. 5B, the communication holes 26 are filled with a conductor 23. The through electrode 23 which has the projecting portion 23a is constituted by this conductor 23.
As the conductor 23, metals such as copper (Cu) and tungsten (W), alloys such as Au-Sn, and nonmetallic conductors such as polysilicon, can be used. As the filling method, it is possible to suitably apply a plating method, a sputtering method, a molten metal filling method, chemical vapor deposition, and the like.

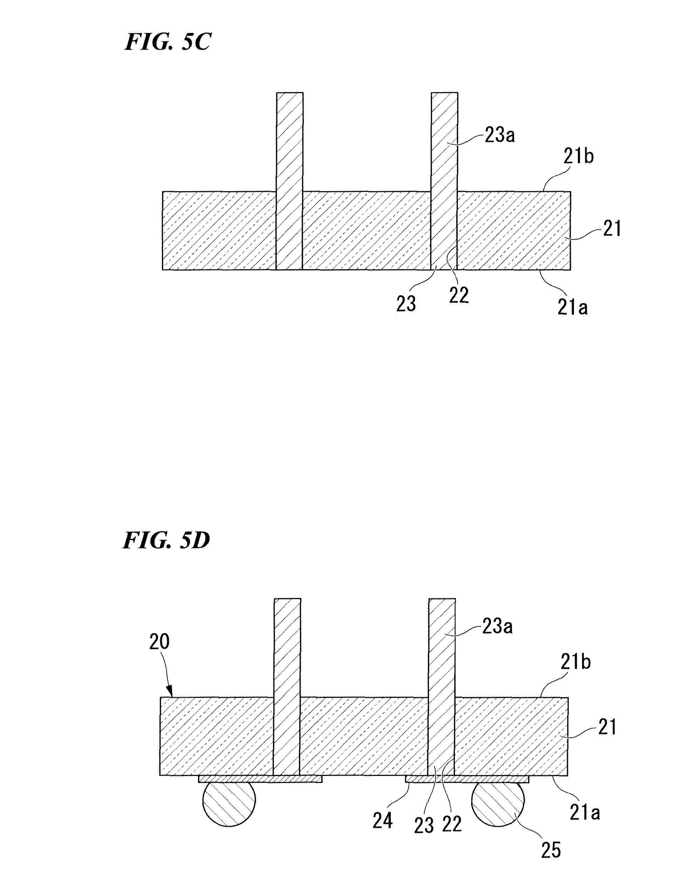

Then, as shown in FIG. 5C, by removing a portion of the base material from the opposite side of the first principal surface 21a of the base material 26 until a portion of the conductor 23 is exposed, the second principal surface 21b of the support substrate 21 is formed, and by the conductor 23 that fills the hole 26a, the through electrode 23 is formed that penetrates the supporting substrate 21 from the first principal surface 21a to the second principal surface 21b, and has the projecting portion 23a that projects from the second principal surface 21b.
Methods of glass removal include dry etching using gas or the like, and wet etching using a chemical solution such as hydrofluoric acid (HF).

Then, as shown in FIG. 5D, the circuit 24 that is electrically connected with the through electrode 23, and the connection terminal 25 such as a solder bump that is electrically connected with the circuit 24 are formed on the first principal surface 21a side of the supporting substrate 21. Thereby, the supporting member 20 of the present embodiment is completed.

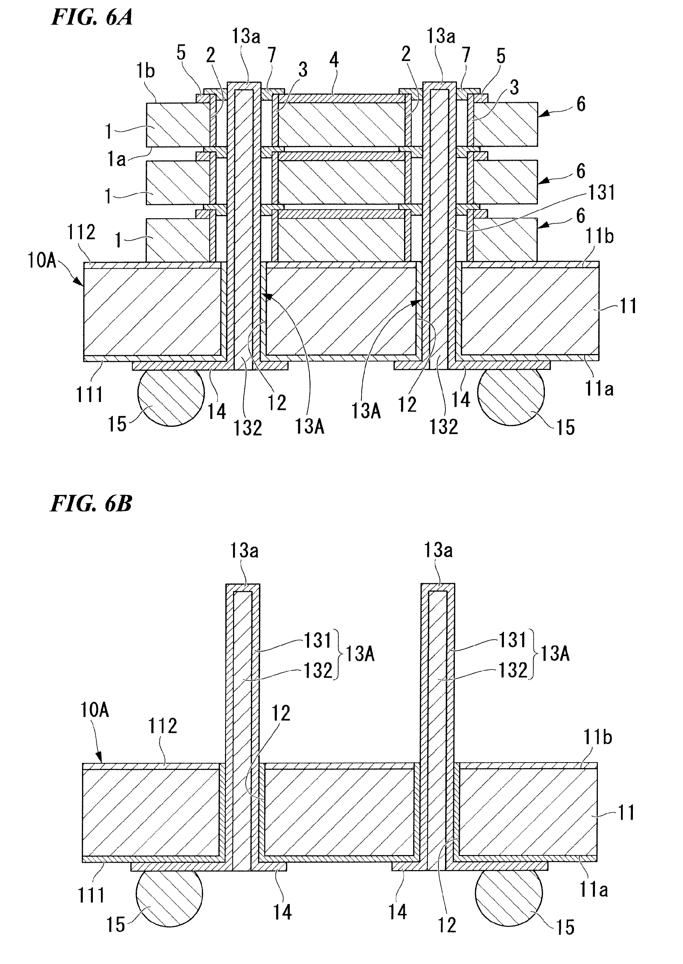

FIG. 6A to FIG. 7D show the electronic device mounting structure and mounting method using a supporting member 10A according to the third embodiment of the present invention.
In the case of the present embodiment, the through electrode 13A that has the projecting portion 13a consists of a plurality of layers (specifically, two layers consisting of an outer layer 131 and an inner layer 132). Here, the outer layer 131 is constituted from a conductor, and is electrically connected with the circuit 4 of the electronic device 6. In addition, the outer layer 131 and the circuit 14 are formed as a continuous conductor layer. The material of the inner layer 132 may be a conductor or an insulator. Further, the inner layer 132 is included in the outer layer 131 at the distal end of the projecting portion 13a.
The electronic device mounting structure of the present embodiment can exhibit the same function effect as the aforementioned first embodiment.

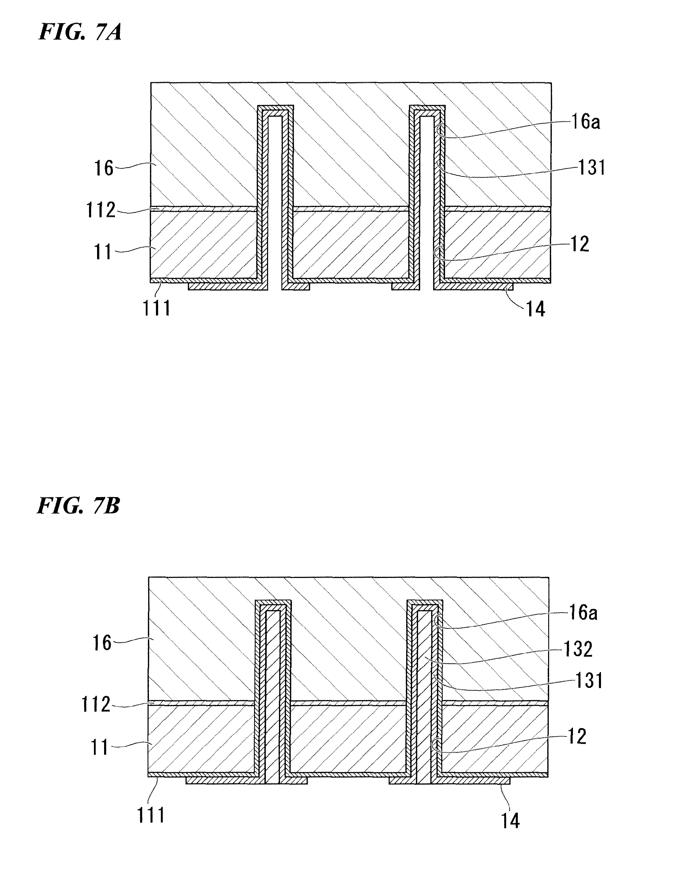

The supporting member 10A of the present embodiment can be manufactured by the manufacturing method shown, for example, in FIG. 2A to FIG. 2D, and subsequently FIG. 7A to FIG. 7D. Here, the steps shown in FIG. 2A to FIG. 2D can be performed in the same manner as the first embodiment, so overlapping descriptions shall be omitted.

In FIG. 7A, a conductor 131 is applied inside the through holes 12 and the communication holes 16a formed in FIG. 2A to FIG. 2D. The aforementioned outer layer 131 is constituted by this conductor 131. Moreover, in the case of the present embodiment, simultaneously with the applying of the outer layer 131, the circuit 14 is formed on the insulating layer 111 by the same conductor. Note that the circuit 14 may also be formed a separate step from the outer layer 131. Further, the circuit 14 may be formed with a different material than the outer layer 131.

As the conductor that constitutes the outer layer 131 and the circuit 14, metals such as copper (Cu) and tungsten (W), alloys such as Au-Sn and solder, and nonmetallic conductors such as polysilicon, can be used. As the applying method, it is possible to suitably apply a plating method, a sputtering method, a molten metal filling method, chemical vapor deposition, and the like.

Next, as shown in FIG. 7B, further to the inner side of the conductor 131 that has been applied inside the inner wall of the through hole 12 and the communication hole 16a, the inner layer 132 is applied. The filling material of the inner layer 132 may be a conductor or it may be an insulator. For example, in the case of applying an insulating resin by vacuum printing for filling, it is possible to impart a certain degree of flexibility to the through electrode 13A that has the projecting portion 13a, and so it is possible to relieve the stress that occurs during mounting of the electronic device 6. Note that the filling material of the inner layer 132 is not limited to insulating resin, and may be another insulator or even a conductor such as metal. As the filling method, it is possible to suitably apply a plating method, a sputtering method, or chemical vapor deposition in accordance with the material.

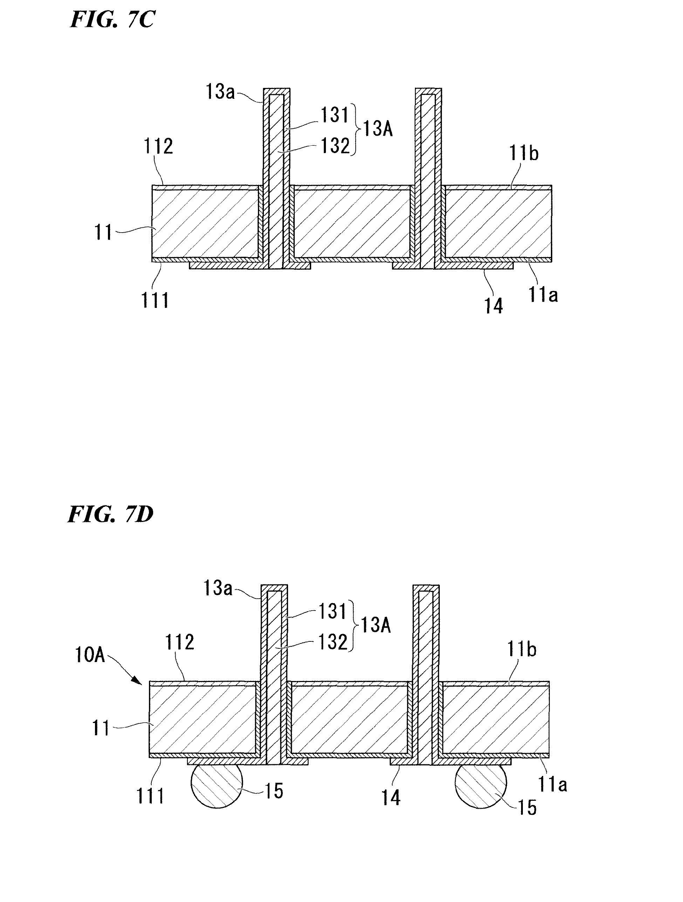

Next, as shown in FIG. 7C, the projecting portion formation auxiliary layer 16 is completely removed. Moreover, when the insulating layer 111 has been formed also in the interior of the communication hole 16a in FIG. 2D, the insulating layer 111 of the projecting portion 13a surface is removed. Thereafter, as shown in FIG. 7D, a connection terminal 15 such as a solder bump that is electrically connected with the circuit 14 is formed on the first principal surface 11a side of the supporting substrate 11. Thereby, the supporting member 10A of the present embodiment is completed. For these steps, it is possible to use the same methods as those described in the first embodiment with FIGS. 3B, 3C, and 3D, so overlapping descriptions will be omitted. Note that although not particularly illustrated, the formation step of the circuit 14 can also be performed by the step shown in FIG. 7D.
The supporting member 10A that is obtained by the present embodiment has a structure in which the inner layer 132 is included within the outer layer 131 at the distal end of the projecting portion 13a.

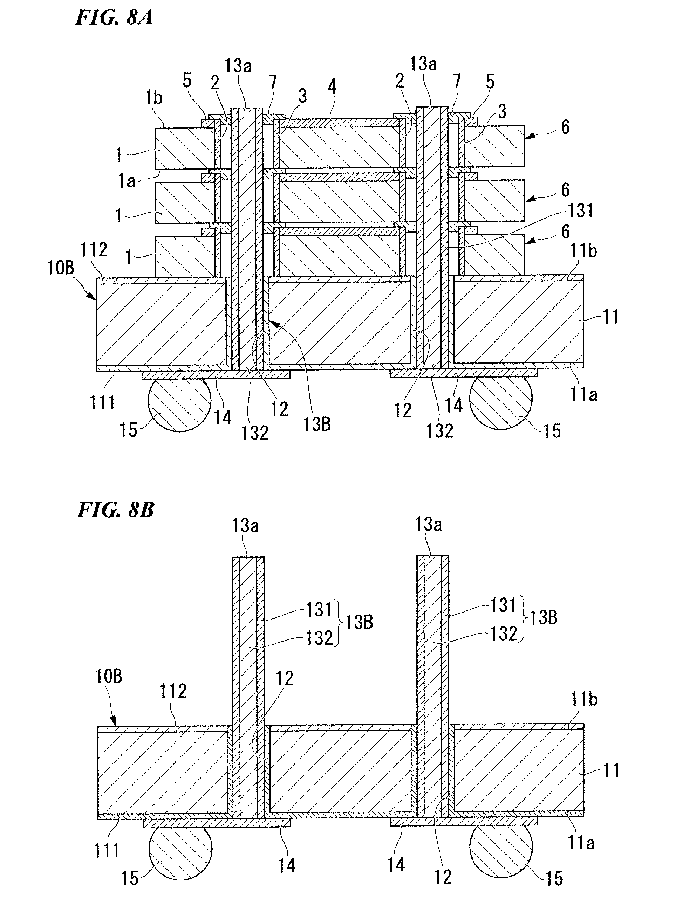

FIG. 8A to FIG. 11D show the electronic device mounting structure and mounting method using the supporting member 10B according to the fourth embodiment of the present invention.
In the case of the present embodiment, the through electrode 13B that has the projecting portion 13a consists of a plurality of layers (specifically, two layers consisting of the outside layer 131 and the inside layer 132). Here, the outer layer 131 is constituted from a conductor, and is electrically connected with the electronic device 6 and the circuit 4. Also, the outer layer 131 and the circuit 14 are formed as a continuous conductor layer. The material of the inner layer 132 may be a conductor or an insulator. Also, the through electrode 13B has a layer structure in which the inner layer 132 is exposed from the outer later 131 at the distal end of the projecting portion 13a.
According to the electronic device mounting structure of the present embodiment, it is possible to exhibit the same function effect of the first and third embodiments described above.

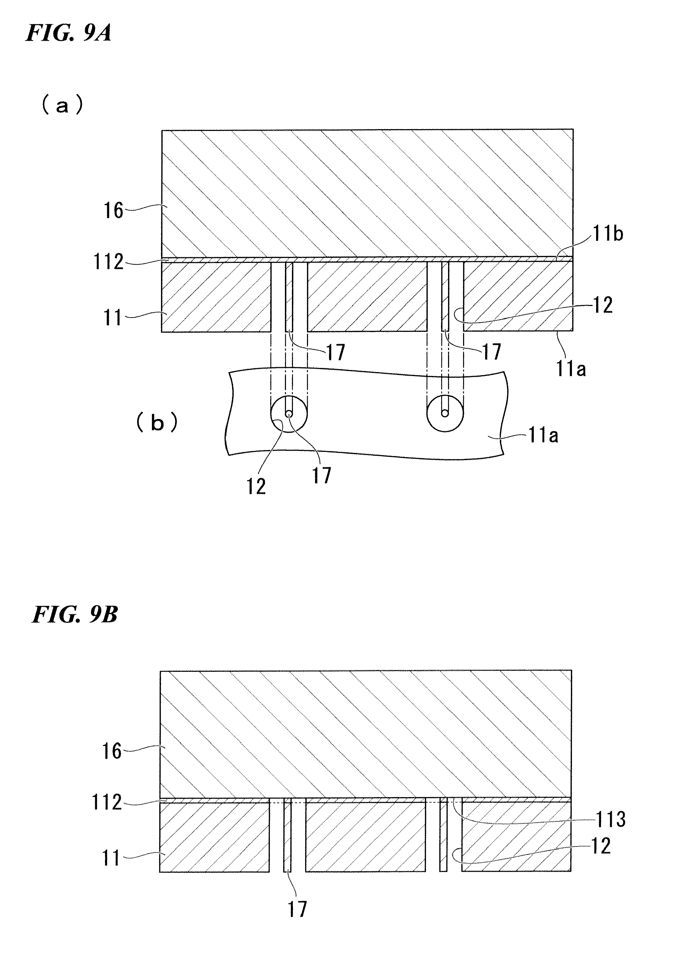

The supporting member 10B of the present embodiment can be manufactured by the manufacturing method shown, for example, in FIGS. 9A to 9C, FIGS. 10A to 10C, and FIGS. 11A to 11D.
In FIG. 9A, as shown in (a), the starting material in which the projecting portion formation auxiliary layer 16 is laminated on the second principal surface 11b side of the supporting substrate 11 (in greater detail, on the insulating layer 112) is the same as the first embodiment described above (for example, an SOI substrate). Note that the through hole 12 that penetrates the supporting substrate 11 from the first principal surface 11a to the second principal surface 11b differs from that in FIG. 2A on the point of having a cross-sectional donut shape as shown in (b) of FIG. 9A, that is, it has a core 17 consisting of the material of the supporting substrate 11 remaining in the center portion of the through hole 12.
As a concrete example of the dimensions of each portion, the thickness of the supporting substrate 11 is, for example, 150 µm, the thickness of the projecting portion formation auxiliary layer 16 is, for example, 200 µm, the height of the projecting portion 13a is, for example, 180 µm, the outer diameter of the through hole 12 is, for example, 60 µm, and the inner diameter of the through hole 12 (that is, the outer diameter of the core 17) is, for example, 30 µm.

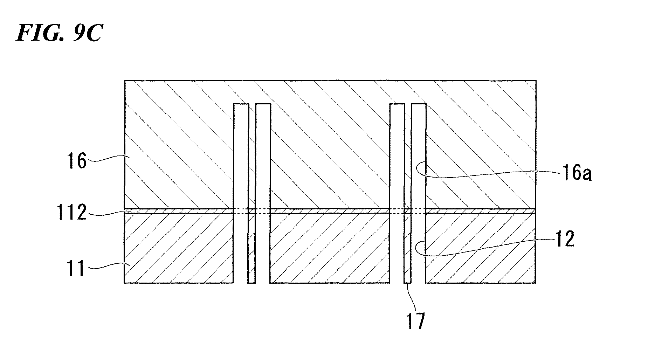

Following the through hole 12, as shown in FIG. 9B, a hole 113 is also formed in the embedded insulating layer 112. Moreover, as shown in FIG. 9C, a communication hole 16a that reaches the interior of the projecting portion formation auxiliary layer 16 is formed extending from the through hole 12. The hole 113 and the communication hole 16a both have a cross-sectional ring shape, that is, have the core 17 that consists of the remaining material of the embedded insulating layer 112 and the projecting portion formation auxiliary layer 16.
The depth of the communication hole 16a in the projecting portion formation auxiliary layer 16 is substantially the same as the height of the projecting portion 13a.

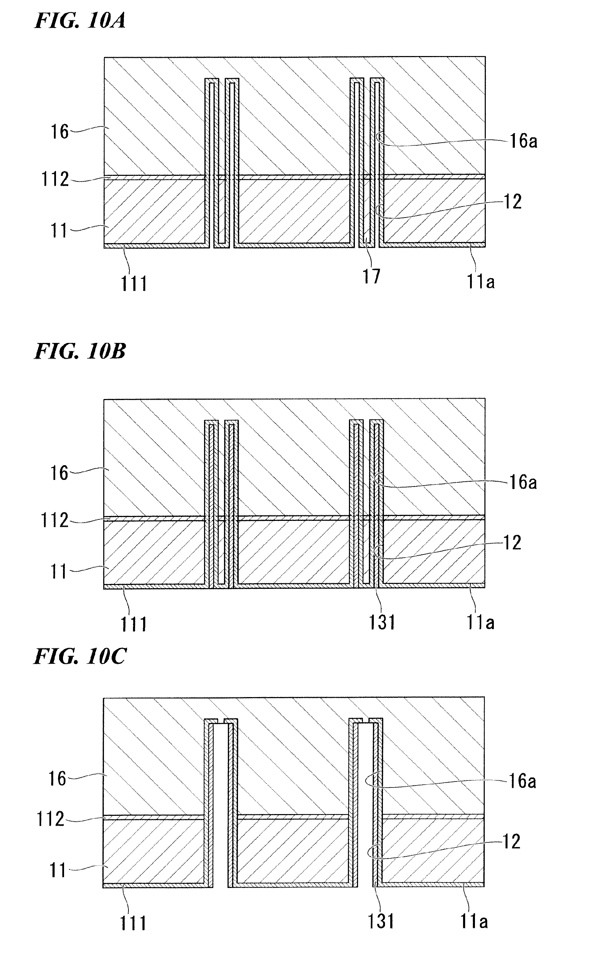

As shown in FIG. 10A, the insulating layer 111 is formed on the inner wall of the through-hole 12 (including the outer wall of the core 17) and the first principal surface 11a of the supporting substrate 11. Note that the formation of the insulating layer 111 is discretionary, and it may be performed as needed. The formation of the insulating layer 111 can be performed in the same manner as the formation of the insulating layer 111 shown in FIG. 2D of the first embodiment, for example.

Subsequently, as shown in FIG. 10B, the through-hole 12 and the communication hole 16a are filled with a conductor 131. The aforementioned outer layer 131 is constituted by this conductor 131. As the conductor 131 used for the outer layer 131, metals such as copper (Cu) and tungsten (W), alloys such as Au-Sn and solder, and nonmetallic conductors such as polysilicon, can be used. As the filling method, it is possible to suitably apply a plating method, a sputtering method, a molten metal filling method, chemical vapor deposition, and the like.

Then, as shown in FIG. 10C, the insulating layer 111 inside the outer layer 131 (that is, on the outer wall of the core 17) and the core 17 are removed. This removal is performed after carrying out necessary protection of the insulating layer 111 that is on the outer side of the outer layer 131 (on the inner wall of the through hole 12 and the communication hole 16a and on the first principal surface 11a). In the case of the starting material being an SOI substrate, Si and SiO₂ are removed by, for example, SF₆ gas, CF₄ gas or the like. It is also possible to use another method.
Methods of protecting the insulating layer 111 that is on the outer side of the outer layer 131 include, for example, a method of coating the first principal surface 11a with a protective material such as a resist from the outer side of the through hole 12 to the conductor 131.

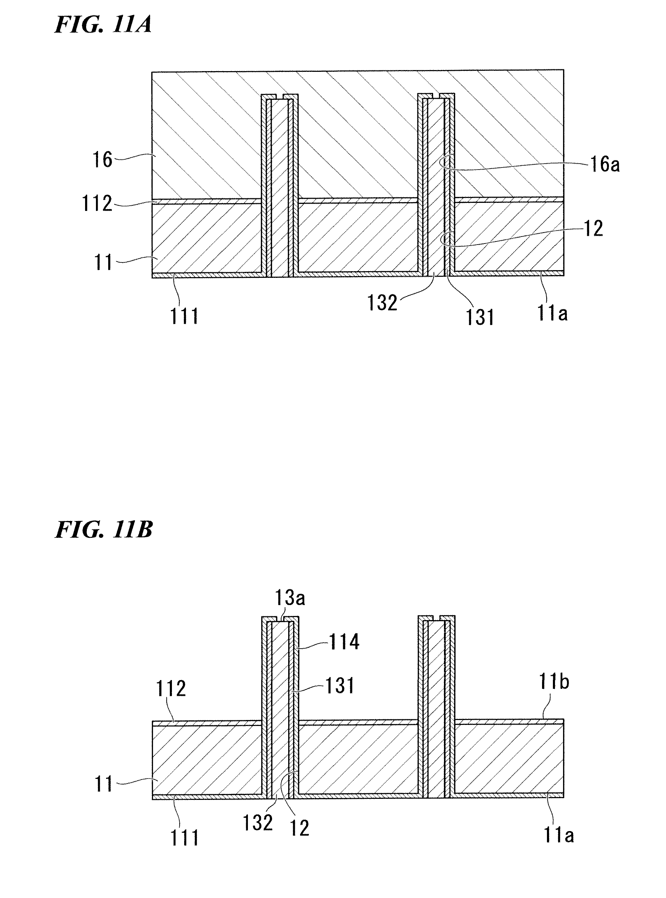

As shown in FIG. 11A, the cavity that has been created inside the conductor 131 is filled with the inner layer 132. The filling material of the inner layer 132 may be a conductor or an insulator. For example, it may be filled with copper (Cu) by plating, or with another conductor or an insulator such as insulating resin. As the filling method, it is possible to suitably apply a plating method, a sputtering method, chemical vapor deposition, printing, and the like in accordance with the material.

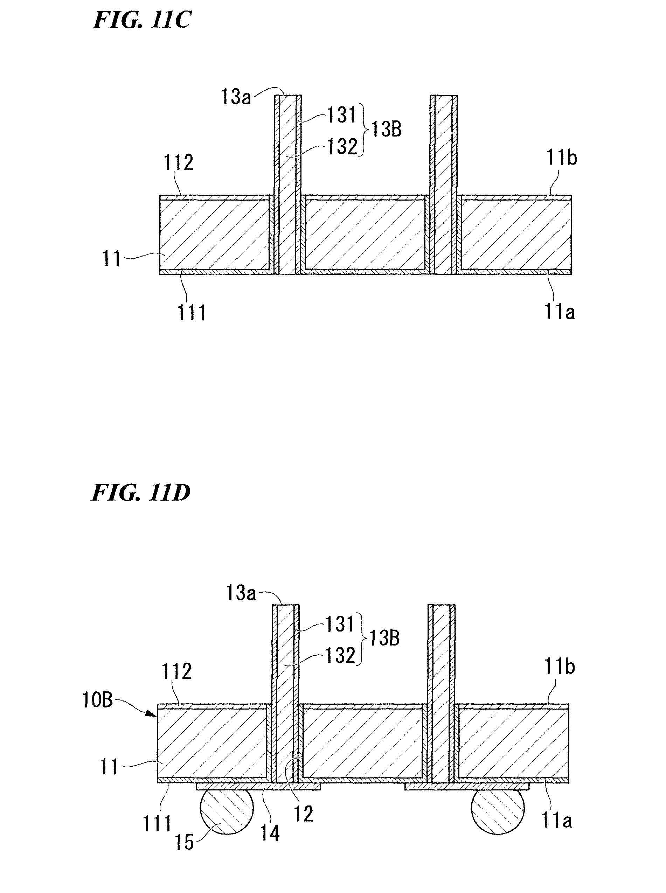

Subsequently, as shown in FIG. 11B, the projecting portion formation auxiliary layer 16 is completely removed, and as shown in FIG. 11C, the insulating layer 111 on the surface of the projecting portion 13a (the portion denoted by reference numeral 114 in FIG. 11 B) is removed. Moreover, as shown in FIG. 11D, a circuit 14 that is electrically connected with the through electrode 13, and a connection terminal 15 such as a solder bump that is electrically connected with the circuit 14 are formed on the first principal surface 11a side of the supporting substrate 11. Thereby, the supporting member 10B of the present embodiment is completed. For these steps, since it is possible to use the same method as described with FIGS. 3B, 3C, 3D in the first embodiment, overlapping descriptions shall be omitted.
In the supporting member 10B that is obtained by the present embodiment, the through electrode 13B has a layer structure in which the inner layer 132 is exposed at the inner side of the outer layer 131 at the distal end of the projecting portion 13a.

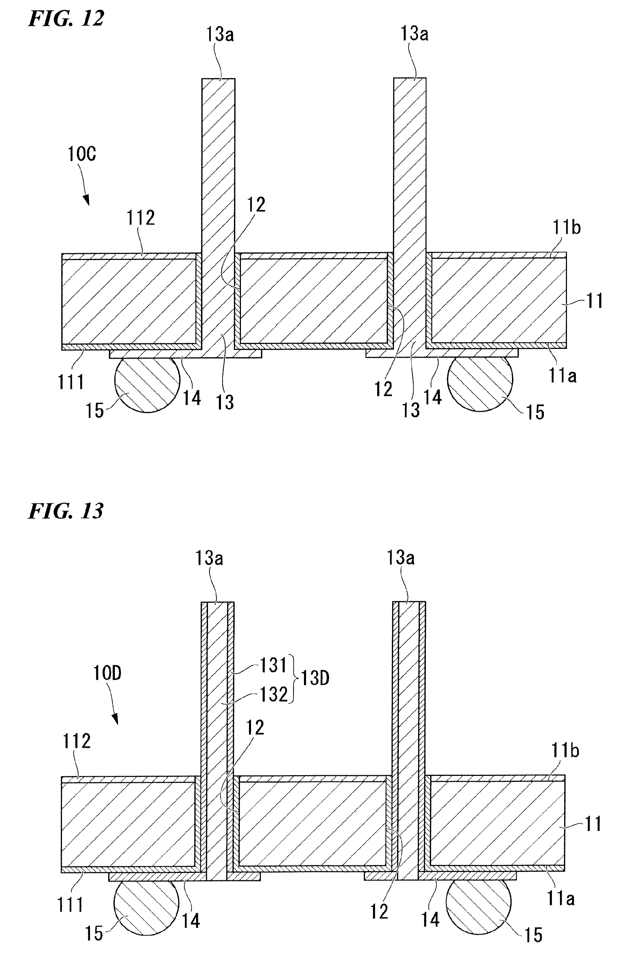

The preferred embodiments of the present invention have hereinabove been described, but the present invention is not limited to the aforementioned embodiments, and various modifications are possible within a scope that does not depart from the gist of the present invention.
The supporting member 10C shown in FIG. 12 is constituted similarly to the supporting member 10 of the first embodiment shown in FIG. 1B, except for the through electrode 13 and the circuit 14 being continuously formed. It is possible to manufacture this supporting member 10C by, for example, forming the circuit 14 simultaneously with the filling step using the conductor 13 shown in FIG. 3A, during the manufacturing step of the supporting member 10 of the first embodiment.

The supporting member 10D shown in FIG. 13 is constituted similarly to the supporting member 10B of the fourth embodiment shown in FIG. 8B, except for the outer layer 131 of the through electrode 13D and the circuit 14 being continuous. It is possible to manufacture this supporting member 10D by, for example, forming the circuit 14 simultaneously with the filling step using the conductor 131 shown in FIG. 10B, during the manufacturing step of the supporting member 10 of the fourth embodiment.

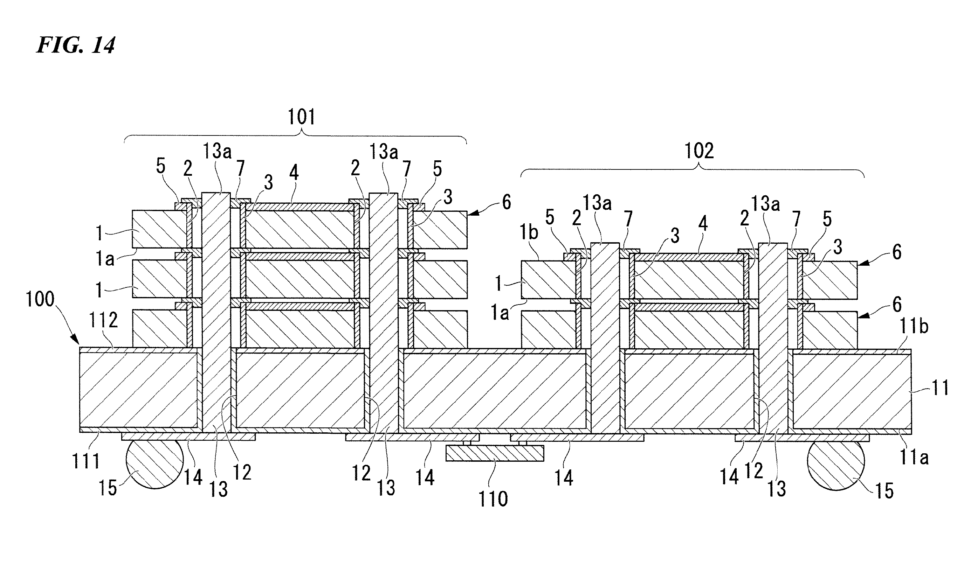

In the electronic device mounting structure that uses the supporting member 100 shown in FIG. 14, the supporting member 100 has, on the second principal surface 11b of the supporting substrate 11, a plurality of device arrangement regions 101, 102 in which the electronic device 6 is arranged by the projecting portion 13a of the through electrode 13. The number of the electronic devices 6 that are arranged in each device arrangement region 101, 102 may be the same or may differ between the regions. Also, the number of electronic devices 6 that are arranged in each device arrangement region 101, 102 may be one or may be plural. It is also possible to mount an electronic device 110 on the circuit 14 on the first principal surface 11a side of the supporting substrate 11 of the supporting member 100.

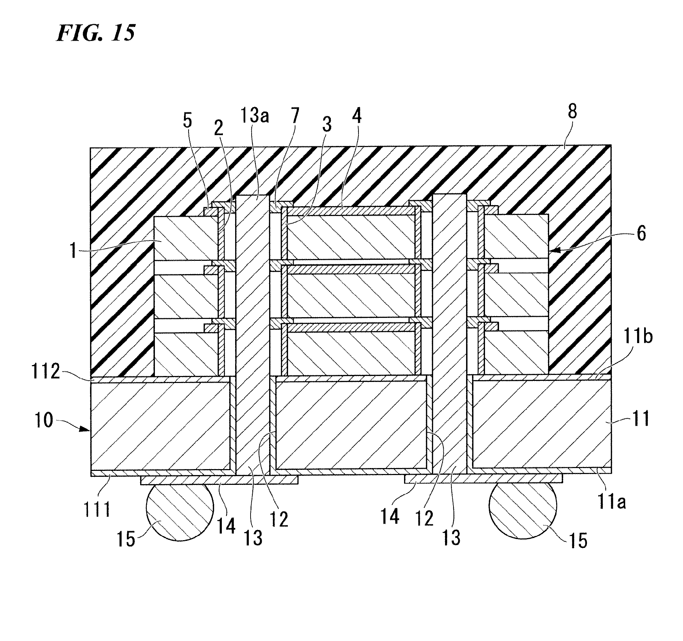

The electronic device mounting structure shown in FIG. 15 has a protective layer 8 that contains the electronic device 6 within itself. Thereby, it is possible to realize a semiconductor package. Although it is possible to constitute the protective layer 8 using, for example, an insulating resin (mold resin), a substrate with a cavity and the like, it is not particularly limited to these.
In addition, when performing mounting of the electronic device 6 and formation of the protective layer 8 prior to forming the circuit 14 and the connection terminal 15 on the first principal surface 1a side of the supporting member, it is possible to make the package thinner by grinding the first principal surface 1a side of the supporting substrate 11 and using this protective layer 8 as a support body. In this case, after grinding the first principal surface side 1a, it is possible to provide the circuit 14 and the connection terminal 15 as required.

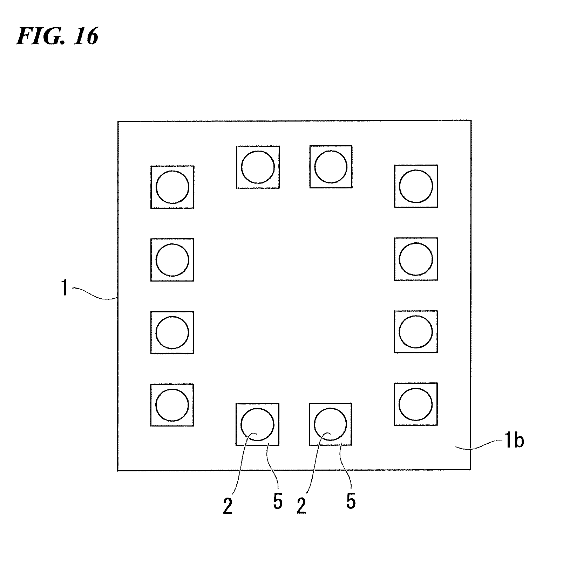

FIG. 16 shows an example of the pad arrangement of the device substrate 1 that is used for the electronic device 6 in each of the aforementioned embodiments. In this example, the pad 5 is formed on the periphery of each of the through holes 2 that are formed on the principal surface 1b of the device substrate 1. Note that the circuit 4 shown in FIG. 1A is omitted in the illustration of FIG. 16. The arrangement of the through hole 2 and the pad 5 can be suitably designed, and the projecting portion is arranged on the supporting member in conformity with this arrangement.
FIG. 16 shows the device substrate 1 that has twelve through holes 2. The number of the projecting portions 13a of the supporting member may be the same number of through holes 2, or may be a fewer number to omit insertion into some of the through holes 2.
The dimensions of the through hole 2 and each portion at its periphery are not particularly limited. As a concrete example, the outer diameter of the projecting portion 13a is, for example, 60 µm, the inner diameter of the through hole 2 is, for example, 80 µm, and the I/O pad 5 is a 100 µm square (100 µm □).

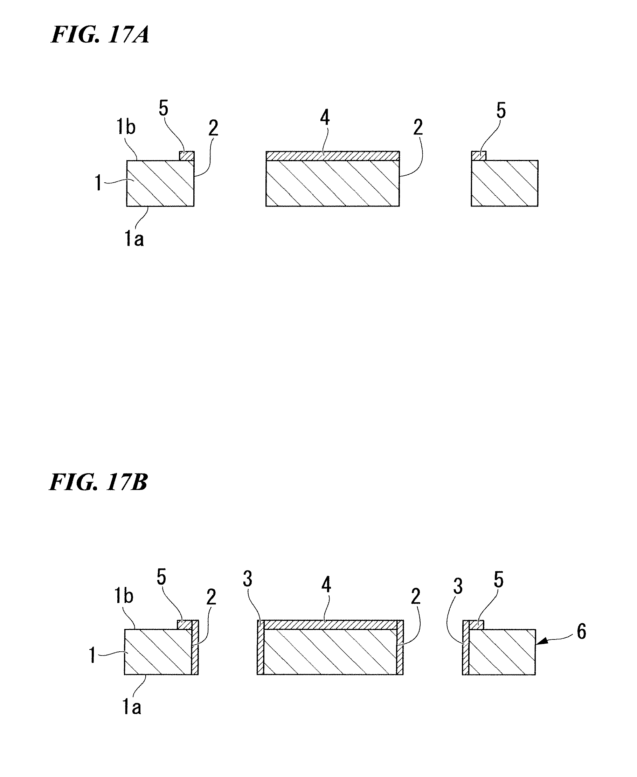

FIG. 17A to FIG. 17D schematically show an example of steps of processing the device substrate 1 to mount on the supporting member 10.
First, as shown in FIG. 17A, through holes 2 are formed in the device substrate 1 and the pad 5.

For example, after protecting with a resist the portions other than where the through hole 2 is formed, and then removing the portion of the pad 5 that is exposed from the resist, the exposed portion of the device substrate 1 is removed to penetrate the through hole 2 from the principal surface 1b to the principal surface 1a, whereby it is possible to form the through hole 2 in the device in which the through hole 2 is not formed. The removal of the pad 5 material, in the case of being, for example, Al, is performed by wet etching using a chemical solution. The removal of the device substrate 1, in the case of being, for example, Si, is performed by the aforementioned Bosch process. For the formation of the through hole 2 in the pad 5 and the device substrate 1, it is also possible to employ other types of dry etching, wet etching, and physical processing by a laser or the like.

In the case of performing back surface grinding on the principal surface 1a side of the device substrate 1, back surface grinding is performed after forming a bottomed hole from the principal surface 1b side with a certain amount of depth (a blind via), and so when the hole reaches the principal surface 1a, penetration can be achieved. The depth of the blind via is not particularly limited, but as a concrete example, the depth of the blind via is, for example, 70 µm, and the device substrate 1 is thinned to a thickness of 50 µm by the back surface grinding.

Next, as shown in FIG. 17B, the insulating layer 3 is formed on the inner wall of the through hole 2. As for the method of forming the insulating layer 3, if it is an insulating layer 3 that consists of, for example, SiO₂, methods of film formation include a plasma chemical vapor deposition method that uses tetraethoxysilane (TEOS) as a raw material, a plasma chemical vapor deposition method that uses silane (SiH₄) or the like, and thermal oxidation of Si. The material of the insulating layer 3 is not limited to SiO₂, and may be other insulating materials, such as silicon nitride (SiN) or insulating resin.

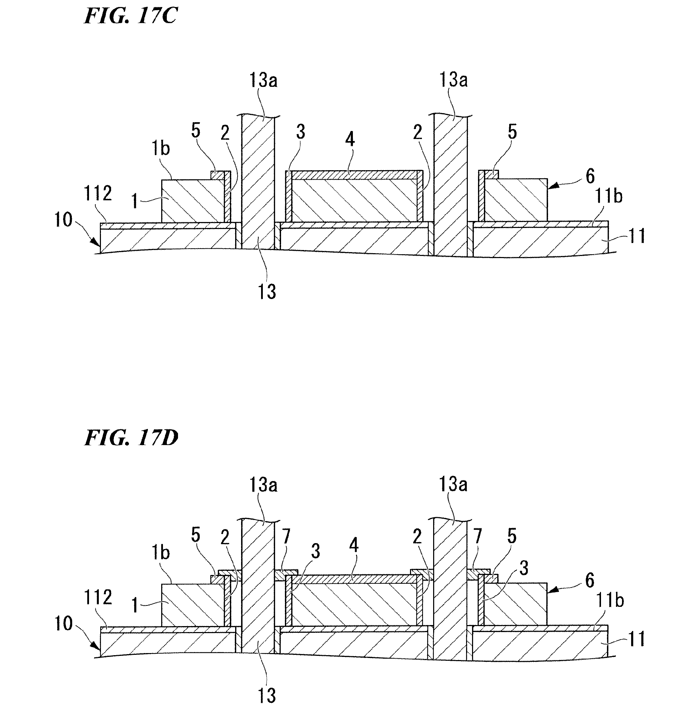

Next, as shown in FIG. 17C, the projecting portion 13a of the through electrode 13 of the support member 10 is inserted into the through hole 2 in which the insulating layer 3 has been formed on the inner wall, and the electronic device 6 is arranged on the second principal surface 11b of the supporting substrate 11. Here, although not illustrated, an adhesive layer or insulating layer may be provided as necessary between the second principal surface 11b and the first principal surface 1a of the device substrate 1.

Next, as shown in FIG. 17D, the I/O pad 5 of the electronic device electronic device 6 and the projecting portion 13a of the through electrode 13 are electrically connected. For this connection, it is possible to use an electrically conductive bonding material 7 such as solder or conductive paste. In the illustration, the electrically conductive bonding material 7 is applied to only the portion in the vicinity of the pad 5, but it may be applied to the entire through hole 2.

Moreover, by repeating the steps shown in FIG. 17C and FIG. 17D, it is possible to layer a plurality of the electronic devices 6 as shown, for example, in FIG. 1B. Here, although not illustrated, an adhesive layer or insulating layer may be provided as necessary between the layered electronic devices 6.

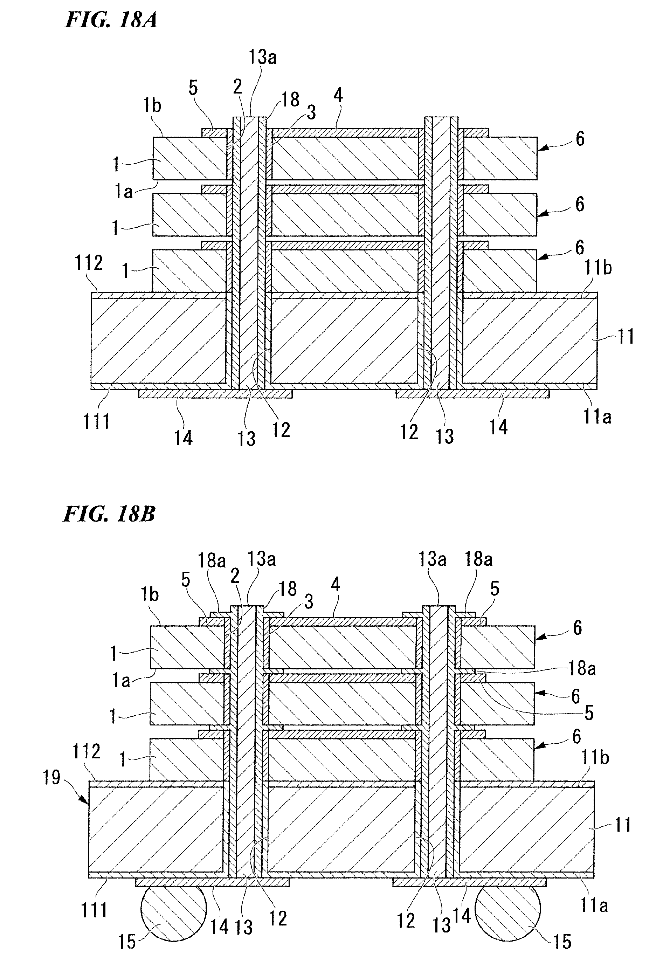

FIG. 18A is a cross-sectional view that schematically shows an example of the state of a layered arrangement of the electronic devices 6 using the supporting member 19 in which a layer of solder 18 is provided on the projecting portion 13a, and FIG. 18B is a cross-sectional view that schematically shows an example of an electronic device mounting structure that is manufactured using the electronic devices that have been arranged in a layered manner as shown in FIG. 18A.
This supporting member 19 corresponds to one in which the outer layer 131 in the supporting member 10B of the fourth embodiment shown in FIG. 8B is replaced with the layer of solder 18. The material with which the inner side of the layer of solder 18 is filled may be a conductor or may be an insulator.
Also, in the example shown in FIGS. 18A and 18B, the layer of solder 18 is formed also inside the through hole 12 of the supporting member 19, but the layer of solder 18 may be provided only on the projecting portion 13a of the through electrode 13 that is formed by a conductor. A method of providing the layer of solder 18 only on the projecting portion 13a includes manufacturing the supporting member 10 shown in FIG. 1B, and then forming the layer of solder 18 by further application of solder paste.

As shown in FIG. 18A, by inserting the projecting portion 13a, on which the layer of solder 18 is formed across the entire length of the outer periphery, into the through hole 2 of a plurality of the electronic devices 6, these electronic devices 6 are arranged in a layered state on the second principal surface 11b of the supporting substrate 11. As shown in FIG. 18B, when the layer of solder 18 is melted by carrying out reflowing at a temperature of the melting point of solder or higher, due to the joining portion 18a that is formed from the solder melted out from the layer of solder 18, it is possible to electrically connect all at once each pad 5 of the plurality of electronic devices 6 and the projecting portion 13a.
According to this method, it is possible to further simplify the mounting step of the electronic devices 6.
Note that in the case of the connecting terminal 15 that is provided on the supporting member 19 being a solder bump, it is possible to form the solder bump 15 after mounting the electronic device 6 by reflowing the layer of solder 18 of the projecting portion 13a. Alternatively, it is possible to simultaneously reflow the layer of solder 18 and the solder bump 15.

### INDUSTRIAL APPLICABILITY

The present invention can be suitably utilized for mounting an electronic device on a semiconductor chip.

### DESCRIPTION OF REFERENCE NUMERALS

1 device substrate (chip substrate)
1a, 1b, principal surface
2 through hole
4 circuit
6 electronic device (semiconductor chip)
8 protection layer
10, 10A, 10B, 10C, 10D, 20, 100 supporting member
11, 21 supporting substrate
11a, 21a first principal surface
11b, 21b second principal surface
12 through hole
13, 13A, 13B, 13D, 23 through electrode
13a, 23a projecting portion
15, 25 connection terminal (solder bump)
16 projecting portion formation auxiliary layer
16a communication hole
18 layer of solder
26 base material
26a base material hole
101, 102 device arrangement regions

## Claims

1. An electronic device mounting structure comprising:
a supporting member that comprises a supporting substrate, and a through electrode that penetrates the supporting substrate from a first principal surface that is one principal surface of the supporting substrate to a second principal surface that is the other principal surface, and that comprises a projecting portion that projects from the second principal surface; and
an electronic device that comprises a device substrate on which a circuit is formed, and a through hole that penetrates between both principal surfaces of the device substrate, wherein
the electronic device is arranged on the second principal surface of the supporting substrate so that the projecting portion of the supporting member is inserted into the through hole, and
the circuit of the electronic device is electrically connected with the projecting portion.

2. The electronic device mounting structure according to claim 1, comprising:
a plurality of the electronic devices, wherein
each of the electronic devices is laminated on the second principal surface of the supporting substrate.

3. The electronic device mounting structure according to claim 1 or claim 2, wherein
the supporting member comprises, on the second principal surface of the supporting substrate, a plurality of device arrangement regions in which the electronic devices are arranged by the projecting portion.

4. The electronic device mounting structure according to any one of claims 1 to 3, further comprising a protective layer that includes the electronic devices within itself.

5. The electronic device mounting structure according to any one of claims 1 to 4, wherein
a layer of solder is formed on the outer periphery surface of the projecting portion over the entire length of the projecting portion, and
the circuit of the electronic device and the projecting portion are electrically connected by solder that is melted out from the layer of solder.

6. The electronic device mounting structure according to any one of claims 1 to 5, wherein
the supporting member comprises a connection terminal on the first principal surface side.

7. An electronic device comprising the electronic device mounting structure according to any one of claims 1 to 6.

8. An electronic device mounting method comprising:
a first step of preparing a supporting member including a supporting substrate, and a through electrode that penetrates the supporting substrate from a first principal surface that is one principal surface of the supporting substrate to a second principal surface that is the other principal surface, and that includes a projecting portion that projects from the second principal surface;
a second step of preparing an electronic device that includes a device substrate, and a through hole that penetrates between both principal surfaces of the device substrate; and
a third step of arranging the electronic device on the second principal surface of the supporting substrate so that the projecting portion of the supporting member is inserted into the through hole of the electronic device, and electrically connecting the circuit of the electronic device and the projecting portion.

9. The electronic device mounting method according to claim 8, wherein the first step comprises:
a step of laminating, on the second principal surface of the supporting substrate, a projecting portion formation auxiliary layer having a thickness greater than the height of the projecting portion;
a step of forming a through hole that penetrates from the first principal surface to the second principal surface of the supporting substrate;
a step of forming a communication hole extending from the through hole of the supporting substrate to reach the interior of the projecting portion formation auxiliary layer;
a step of filling with a conductor the through hole of the supporting substrate and the communication hole; and
a step of exposing the second principal surface of the supporting substrate by removing the projecting portion formation auxiliary layer, and forming a through electrode that consists of the conductor, penetrates the supporting substrate from the first principal surface to the second principal surface, and includes the projecting portion that projects from the second principal surface.

10. The electronic device mounting method according to claim 8, wherein the first step comprises:
a step of forming a hole in a base material that has a thickness greater than the sum of the thickness of the supporting substrate and the height of the projecting portion from a surface that becomes the first principal surface of the supporting substrate;
a step of filling the hole with a conductor; and
a step of forming the second principal surface of the supporting substrate by removing a portion of the base material from the opposite side of the first principal surface of the base material until a portion of the conductor is exposed, and forming a through electrode that consists of the conductor, penetrates the supporting substrate from the first principal surface to the second principal surface, and includes the projecting portion that projects from the second principal surface.

11. The electronic device mounting method according to any one of claims 8 to 10, wherein
the first step comprises a step of forming a layer of solder on the outer periphery surface of the projecting portion over the entire length of the projecting portion, and
the third step comprises a step of inserting the projecting portion of the supporting member into each through hole of a plurality of the electronic devices to arrange the electronic devices in a layered manner on the second principal surface of the supporting substrate, and a step of electrically connecting all at once each circuit of the plurality of electronic devices and the projecting portion by melting the layer of solder.
